# EUROPEAN PATENT SPECIFICATION

(11) **EP 1 005 117 B1**
(45) Date of publication and mention of the grant of the patent: **24.03.2004**
(21) Application number: 99123033.5
(22) Date of filing: 19.11.1999
(51) Int. Cl.: H01S 3/081, H01S 5/14

(54) **External cavity type tunable semiconductor laser source**
Verstimmbare Laserlichtquelle mit externem Resonator
Source de lumière laser accordable à cavité externe

(30) Priority: 25.11.1998 JP 33442198
(43) Date of publication of application: 31.05.2000
(73) Proprietor: ANDO ELECTRIC CO., LTD., Tokyo 144 (JP)
(72) Inventor: Asami, Keisuke, c/o Ando Electric Co., Ltd., Tokyo (JP); Akikuni, Fumio, c/o Ando Electric Co., Ltd., Tokyo (JP)
(74) Representative: Grünecker, Kinkeldey, Stockmair & Schwanhäusser Anwaltssozietät

(56) References cited:
- DE-A- 19 544 897
- PATENT ABSTRACTS OF JAPAN vol. 007, no. 166 (E-188), 21 July 1983 (1983-07-21) & JP 58 071687 A (RICOH KK), 28 April 1983 (1983-04-28)
- LIU K ET AL: "NOVEL GEOMETRY FOR SINGLE-MODE SCANNING OF TUNABLE LASERS" OPTICS LETTERS,US,OPTICAL SOCIETY OF AMERICA, WASHINGTON, vol. 6, no. 3, 1 March 1981 (1981-03-01), pages 117-118, XP000710138 ISSN: 0146-9592
- PATENT ABSTRACTS OF JAPAN vol. 014, no. 161 (E-0909), 28 March 1990 (1990-03-28) & JP 02 016782 A (TOSHIBA CORP), 19 January 1990 (1990-01-19)

## Description

### BACKGROUND OF THE INVENTION

### 1. Field of the Invention

This invention relates to an external cavity type tunable semiconductor laser source used in coherent light communication and measurement technology fields.

### 2. Description of the Related Art

An external cavity type tunable semiconductor laser source generally consists of a semiconductor laser, which will be hereinafter abbreviated to LD, coated on one end face with a reflection prevention film, a lens for converting light from the LD into collimated light, and a wavelength selection element for selecting any desired wavelength.

Mainly, a narrow-band-pass filter, a diffraction grating, etc., is used as the wavelength selection element.

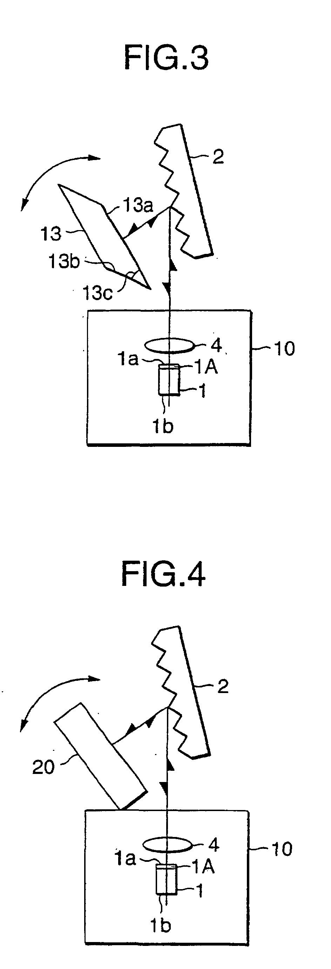

Most of all, in an external cavity type tunable LD light source using a diffraction grating, a system called Littman-Metcalf configuration is frequently used because it provides high wavelength selectivity. In the Littman-Metcalf configuration, a mirror 20 is used in addition to an LD 1, a lens 4, and a diffraction grating 2, as shown in FIG. 4.

According to the Littman-Metcalf configuration shown in FIG. 4, emitted light from the LD 1 is converted into collimated light through the lens 4 and is made incident on the diffraction grating 2, through which a wavelength is selected, then the light of the selected wavelength is once applied to the mirror 20 and is reflected thereon, then the reflected light is again made incident on the diffraction grating 2 and is fed back into the LD 1, thereby providing excellent wavelength selectivity.

However, in the Littman-Metcalf configuration, it is necessary to attach the mirror 20 to a position near the LD 1 and the lens 4 because of the characteristic of the diffracted light emission direction of the diffraction grating 2 and to select a wavelength, the mirror 20 needs to be turned so as not to hit a cabinet 10 for housing the LD 1 and the lens 4, thus there has been a tendency to lengthen the external resonator length.

### SUMMARY OF THE INVENTION

It is therefore an object of the invention to provide an external cavity type tunable semiconductor laser source which shortens the external resonator length in an external cavity type tunable LD light source, thereby providing stable laser oscillation.

To achieve the above object, according to a first aspect of the invention, there is provided an external cavity type tunable semiconductor laser source for converting emitted light from a semiconductor laser into collimated light through a lens, making the light incident on a diffraction grating, through which a wavelength is selected, then once applying the light of the selected wavelength to a mirror and reflecting the light the reflection face of the mirror, then again making the reflected light incident on the diffraction grating and feeding back the light into the semiconductor laser, characterized in that the mirror is formed roughly like a pillar and the angle, which a side of the mirror closest to a cabinet for housing the semiconductor laser and the lens forms with the reflection face of the mirror coated with a surface reflection film, is formed as an acute angle.

According to the first aspect of the invention, the mirror is formed roughly like a pillar and the angle which the side closest to the cabinet for housing the semiconductor laser and the lens forms with the reflection face of the mirror coated with a surface reflection film is formed as an acute angle. Thus, for example, as compared with use of a general mirror shaped like a rectangular parallelepiped, it is made possible to bring the reflection face of the mirror closer to the cabinet.

That is, it is made possible to shorten the external resonator length of the external cavity type tunable semiconductor laser source, whereby stable lasing can be realized.

In a second aspect of the invention, in the external cavity type tunable semiconductor laser source as set forth in the first aspect of the invention, the mirror is formed so as to be able to turn.

According to the second aspect of the invention, the mirror is formed so as to be able to turn, so that wavelength sweeping corresponding to the turning angle of the mirror is enabled.

With such an external cavity type tunable semiconductor laser source, there is a tendency to lengthen the external resonator length as the mirror turns, thus the effect produced by using the mirror with the angle which the side closest to the cabinet with the reflection face formed as an acute angle becomes furthermore large.

In a third aspect of the invention, in the external cavity type tunable semiconductor laser source as set fourth in the first or second aspect of the invention, an intersection point of an line extended vertically to an optical axis with an optical position of an end face of the semiconductor laser away from the diffraction grating with respect to the diffraction grating as a starting point and an extension of a diffraction face of the diffraction grating is matched with the turning center of the mirror, and
the mirror is placed so that the extension of the reflection face of the mirror passes through the intersection point.

According to the third aspect of the invention, the intersection point of the line extended vertically to the optical axis with the optical position of the end face of the semiconductor laser away from the diffraction grating with respect to the diffraction grating as the starting point and the extension of the diffraction face of the diffraction grating is matched with the turning center of the mirror, and the mirror is placed so that the extension of the reflection face of the mirror passes through the intersection point, thus occurrence of mode hop can be prevented over a wide range and continuous wavelength sweeping with less variations in light output is enabled.

With such an external cavity type tunable semiconductor laser source, there is a tendency to furthermore lengthen the external resonator length because the turning radius of the mirror is large, thus the effect produced by using the mirror with the angle which the side closest to the cabinet with the reflection face formed as an acute angle becomes still more large.

In a fourth aspect of the invention, in the external cavity type tunable semiconductor laser source as set forth in the first to third aspects of the invention, the mirror is formed of a triangular prism.

According to the fourth aspect of the invention, the mirror is formed of a triangular prism easily molded, so that the cost of the mirror can be reduced.

In a fifth aspect of the invention, in the external cavity type tunable semiconductor laser source as set forth in any of the first to third aspects of the invention, the mirror is formed of a parallelogram prism.

According to the fifth aspect of the invention , the mirror is formed of a parallelogram prism easily molded so that the cost of the mirror can be reduced.

### BRIEF DESCRIPTION OF THE DRAWINGS

In the accompanying drawings:
FIG. 1 is a block diagram to show an example of an external cavity type tunable LD light source incorporating the invention;
FIG. 2 is a drawing to describe the placement and the operation of a mirror forming a part of the external cavity type tunable LD light source in FIG. 1;
FIG. 3 is a block diagram to show an example of an external cavity type tunable LD light source wherein a mirror is formed of a parallelogram prism; and
FIG. 4 is a block diagram to show an example of an external cavity type tunable LD light source in a related art (Littman-Metcalf configuration).

### DETAILED DESCRIPTION OF THE PREFERRED EMBODIMENTS

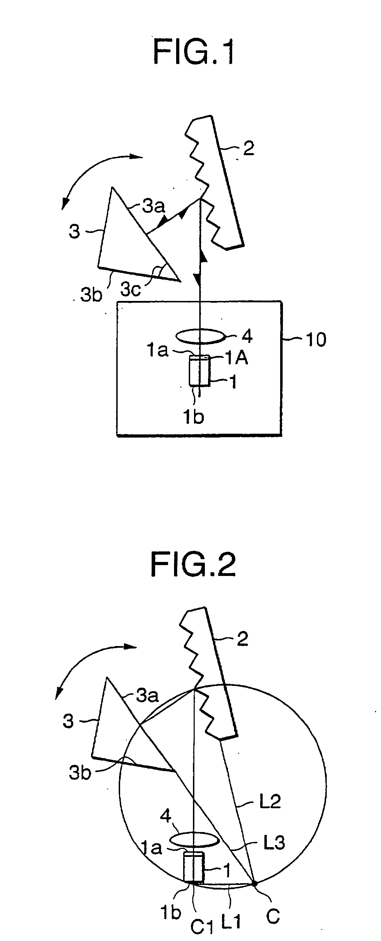

Referring now to the accompanying drawings (FIGS. 1 to 3), there is shown an embodiment of the invention.

FIG. 1 is a block diagram to show an example of an external cavity type tunable LD light source incorporating the invention. FIG. 2 is a drawing to describe the placement and the operation of a mirror forming a part of the external cavity type tunable LD light source in FIG. 1.

The external cavity type tunable LD light source of the embodiment is made up of an LD 1 coated on one end face 1a with a reflection prevention film 1A, a diffraction grating 2 as a wavelength selection element, a triangular prism 3 shown as an example of a mirror, a lens 4 for converting light from the LD 1 into collimated light, a cabinet 10 for housing the LD 1 and the lens 4, and the like.

The triangular prism 3 is formed roughly like a triangle pole and an angle 3c which a side 3b closest to the cabinet 10 forms with a reflection face 3a coated with a surface reflection film is formed as an acute angle. Thus, for example, as compared with a general mirror 20 shaped like a rectangular. parallelepiped (FIG. 4), it is made possible to bring the reflection face 3a closer to the cabinet 10 for shortening the external resonator length.

According to the external cavity type tunable LD light source in FIG. 1, light emitted from the end face 1a of the LD 1 is converted into collimated light through the lens 4, then is incident on the diffraction grating 2.

Diffracted light incident on the diffraction grating 2 and having a wavelength selected therethrough is once vertically incident on the triangular prism 3 and is totally reflected on the reflection face 3a of the triangular prism 3, then is returned to the diffraction grating 2. That is, the wavelength is selected twice through the diffraction grating 2, whereby the wavelength selectivity is enhanced.

The light whose wavelength is thus selected is gathered through the lens 4 and is fed back into the LD 1. That is, an end face 1b of the LD 1 and the diffraction grating 2 make up an external resonator for laser oscillation.

The emitted light from the end face 1b of the LD 1 passes through a lens, a light isolator, etc., (not shown) and is gathered, then is taken out as output light through an optical fiber.

The external cavity type tunable LD light source in FIG. 1 is provided with a turning mechanism (not shown) capable of turning the triangular prism 3 and the triangular prism 3 is turned by the turning mechanism, whereby wavelength sweeping is enabled.

Here, the turning center of the triangular prism 3 matches an intersection point C of a line L1 extended vertically to the optical axis with an optical position C1 of the end face 16 of the LD 1 with respect to the diffraction grating 2 (position of the end face 1b with respect to the diffraction grating 2 if the length in the optical axis direction of the lens 4 and the LD 1) as the starting point and an extension L2 of a diffraction face of the diffraction grating 2.

The triangular prism 3 is placed so that an extension L3 of the reflection face 3a of the triangular prism 3 passes through the intersection point C.

Such placement of the triangular prism 3, the diffraction grating 2, and the LD 1 is disclosed in "Novel geometry for single-mode scanning of tunable lasers, Karen Liu & Michael G.Littman/March 1981/Vol. 6 No. 3/Optics Letters p177-p178" and according to the placement, occurrence of mode hop can be prevented in a wide range and continuous wavelength sweeping with less variations in light output is enabled.

The turning mechanism for turning the triangular prism 3 can be made up of, for example, a sine bar held rotatably with the intersection point C as the axis center and drive means for rotating the sine bar, such as a direct-acting motor. In this case, the triangular prism 3 is fixedly secured on a bottom face (rear face viewed from FIG. 1) to the tip side of the sine bar to lessen the effect produced by thermal expansion, etc. Here, the triangular prism 3 is a pillar-like mirror rather than a flat-panel mirror, thus is fixed to the sine bar in a stable state.

Thus, according to the external cavity type tunable LD light source of the embodiment, the mirror is formed of the triangular prism 3 and the angle 3c which the side 3b closest to the cabinet 10 forms with the reflection face 3a coated with the surface reflection film is formed as an acute angle. Thus, for example, as compared with use of a general mirror shaped like a rectangular parallelepiped, it is made possible to bring the reflection face 3a of the mirror closer to the cabinet 10.

That is, it is made possible to shorten the external resonator length of the external cavity type tunable semiconductor laser source, whereby stable laser oscillation can be realized.

The intersection point C of the line L1 extended vertically to the optical axis with the optical position C1 of the end face 1b of the LD 1 with respect to the diffraction grating 2 as the starting point and the extension L2 of the diffraction face of the diffraction grating 2 is matched with the turning center of the triangular prism 3, and the triangular prism 3 is placed so that the extension L3 of the reflection face 3a of the triangular prism 3 passes through the intersection point C, thus occurrence of mode hop can be prevented in a wide range and continuous wavelength sweeping with less variations in light output is enabled.

In such placement, there is a tendency to lengthen the external resonator length because the turning radius of the mirror is large; however, the external resonator length is shortened by using the triangular prism 3 as the mirror.

Therefore, the external cavity type tunable LD light source adopting such placement can also provide stable laser oscillation.

In the embodiment, as the mirror, the triangular prism 3 is shown as an example, but the scope of the invention is not limited to it. Any mirror may be adopted if it is formed roughly like a pillar, such as a parallelogram prism 13 as shown in FIG. 3, and the angle (here, angle 13C) which the side closest to a cabinet 10 (here, side 13b) forms with the reflection face coated with a surface reflection film (here, reflection face 13a) is formed as an acute angle.

The placement of the triangular prism 3, the diffraction grating 2, and the LD 1 forming the external cavity type tunable semiconductor laser source is not limited to the placement shown in FIG. 2; for example, it may be general Littman-Metcalf configuration.

Any other specific detail structure, etc., can also be changed whenever necessary, needless to say.

According to the first aspect of the invention, the mirror is formed roughly like a pillar and the angle which the side closest to the cabinet for housing the semiconductor laser and the lens forms with the reflection face coated with a surface reflection film is formed as an acute angle. Thus, for example, as compared with use of a general mirror shaped like a rectangular parallelepiped, it is made possible to bring the reflection face of the mirror closer to the cabinet.

That is, it is made possible to shorten the external resonator length of the external cavity type tunable semiconductor laser source, whereby stable laser oscillation can be realized.

According to the second aspect of the invention, the mirror is formed so as to be able to turn, so that wavelength sweeping corresponding to the turning angle of the mirror is enabled.

With such an external cavity type tunable semiconductor laser source, there is a tendency to lengthen the external resonator length as the mirror turns, thus the effect produced by using the mirror with the angle which the side closest to the cabinet with the reflection face formed as an acute angle becomes furthermore large.

According to the third aspect of the invention, the intersection point of the line extended vertically to the optical axis with the optical position of the end face of the semiconductor laser away from the diffraction grating with respect to the diffraction grating as the starting point and the extension of the diffraction face of the diffraction grating is matched with the turning center of the mirror, and the mirror is placed so that the extension of the reflection face of the mirror passes through the intersection point, thus occurrence of mode hop can be prevented over a wide range and continuous wavelength sweeping with less variations in light output is enabled.

With such an external cavity type tunable semiconductor laser source, there is a tendency to furthermore lengthen the external resonator length because the turning radius of the mirror is large, thus the effect produced by using the mirror with the angle which the side closest to the cabinet with the reflection face formed as an acute angle becomes still more large.

According to the fourth aspect of the invention, the mirror is formed of a triangular prism easily molded, so that the cost of the mirror can be reduced.

According to the fifth aspect of the invention, the mirror is formed of a parallelogram prism easily molded, so that the cost of the mirror can be reduced.

## Claims

1. An external cavity type tunable semiconductor laser source for converting emitted light from a semiconductor laser (1) into collimated light through a lens (4), making the light incident on a diffraction grating (2), through which a wavelength is selected, then once applying the light of the selected wavelength to a mirror (13,3) and reflecting the light thereon, then again making the reflected light incident on the diffraction grating (2) and feeding back the light into the semiconductor laser, comprising:
a lens (4) for converting an emitted light from a semiconductor laser into a collimated light; and
a diffraction grating (2) which inputs the collimated light and selects a wavelength of the light;
wherein the light of the wavelength selected by said diffraction grating (2) is reflected by a reflection face (13a,3a) of said mirror once and then inputted to said diffraction grating and fed back to said semiconductor laser; and
wherein said mirror (13,3) is formed roughly like a pillar and the angle, which a side face (13c,3c) of the mirror closest to a cabinet (10) for housing the semiconductor laser (1) and said lens forms with a reflection face (13a,3a) of the mirror coated with a surface reflection film, is formed as an acute angle.

2. The external cavity type tunable semiconductor laser source as claimed in claim 1 wherein said mirror (13,3) is rotatable.

3. The external cavity type tunable semiconductor laser source as claimed in claim 1 wherein an intersection point C of a line L1 extended vertically to the optical axis of the semiconductor laser with an optical position C1 of an end face (16) of the semiconductor laser (1) away from said diffraction grating (2) with respect to said diffraction grating as a starting point and an extension L2 of a diffraction face of said diffraction grating (2) is matched with the turning center of said mirror (13,3); and
wherein said mirror (13,3) is placed so that the extension L3 of the reflection face (13a,3a) of said mirror passes through the intersection point C.

4. The external cavity type tunable semiconductor laser source as claimed in claim 1 wherein said mirror (13,3) comprises a triangular prism (3).

5. The external cavity type tunable semiconductor laser source as claimed in claim 1 wherein said mirror (13,3) comprises a parallelogram prism (13).

## Patentansprüche

1. Eine verstimmbare Halbleiterlaserquelle mit extemem Resonator, um Licht, welches von einem Halbleiterlaser(1) ausgesandt wird, durch eine Linse (4) in kollimiertes Licht umzusetzen, das Licht auf ein Beugungsgitter (2) einfallen zu lassen, durch welches eine Wellenlänge ausgewählt wird, nachfolgend das Licht der ausgewählten Wellenlänge einmal auf einen Spiegel (13,3) anzuwenden und das Licht an demselben zu reflektieren, nachfolgend wiederum das reflektierte Licht auf das Beugungsgitter (2) einfallen zu lassen und das Licht in den Halbleiterlaser zurückzuführen, wobei die Halbleiterlaserquelle umfasst:
eine Linse (4), um ein Licht, welches von einem Halbleiterlaser ausgesandt wird, in ein kollimiertes Licht umzusetzen; und
ein Beugungsgitter (2), auf welches das kollimierte Licht einfällt und welches eine Wellenlänge des Lichtes auswählt;
wobei das Licht mit der durch das Beugungsgitter (2) ausgewählten Wellenlänge von einer Reflexionsfläche (13a, 3a) des Spiegels einmal reflektiert wird und nachfolgend dem Beugungsgitter zugeführt wird und zurück zu dem Halbleiterlaser geführt wird; und
wobei der Spiegel (13, 3) nahezu wie eine Säule ausgebildet ist und der Winkel, welchen eine Seitenfläche (13c, 3c) des Spiegels, welche einem Gehäuse (10) am nächsten ist, welches den Halbleiterlaser (1) und die Linse aufnimmt mit der Reflexionsfläche (13a, 3a) des Spiegels, welche mit einem Oberflächenreflexionsfilm beschicht ist, bildet, als ein spitzer Winkel ausgebildet ist.

2. Die verstimmbare Halbleiterlaserquelle mit extemem Resonator gemäß Anspruch 1, wobei der Spiegel (13, 3) drehbar ist.

3. Die verstimmbare Halbleiterlaserquelle mit externem Resonator gemäß Anspruch 1, wobei ein Schnittpunkt C einer Linie L1, welche sich senkrecht zu der optischen Achse des Halbleiterlasers erstreckt, mit einer optische Position C1 einer von dem Beugungsgitter (2) abgewandten Endfläche (1b) des Halbleiterlasers (1) in Bezug auf das Beugungsgitter als Fußpunkt und einer Fortsetzung L2 einer Beugungsfläche des Beugungsgitters (2) mit dem Drehpunkt des Spiegels (13, 3) übereinstimmend gemacht wird; und
wobei der Spiegel (13, 3) so angeordnet ist, dass die Fortsetzung L3 der Reflexionsfläche (13a, 3a) des Spiegels durch den Schnittpunkt C verläuft.

4. Die verstimmbare Halbleiterlaserquelle mit extemem Resonator gemäß Anspruch 1, wobei der Spiegel (13, 3) ein dreieckiges Prisma (3) umfasst.

5. Die verstimmbare Halbleiterlaserquelle mit extemem Resonator gemäß Anspruch 1, wobei der Spiegel (13, 3) ein Parallelogrammprisma (13) umfasst.

## Revendications

1. Source de lumière de laser accordable semiconducteur à cavité externe servant à convertir une lumière émise par un laser semiconducteur (1) en une lumière collimatée à travers une lentille (4), en rendant la lumière incidente sur un réseau de diffraction (2), par l'intermédiaire duquel une longueur d'onde est sélectionnée, en appliquant alors une fois la lumière de la longueur d'onde sélectionnée à un miroir (13, 3) et en y faisant réfléchir la lumière, en rendant ensuite encore la lumière réfléchie incidente sur le réseau de diffraction (2) et en retournant la lumière dans le laser semiconducteur, comprenant :
une lentille (4) pour convertir une lumière émise depuis un laser semiconducteur en une lumière collimatée ; et
un réseau de diffraction (2) qui reçoit la lumière collimatée et sélectionne une longueur d'onde de la lumière ;
dans laquelle la lumière de la longueur d'onde sélectionnée par ledit réseau de diffraction (2) est réfléchie par une surface de réflexion (13a, 3a) dudit miroir une fois et ensuite délivrée audit réseau de diffraction et retournée audit laser semicoducteur ; et
dans laquelle ledit miroir (13, 3) est formé approximativement sous forme de colonne et l'angle, qu'une face latérale (13c, 3c) du miroir la plus proche d'un coffret (10) logeant le laser semiconducteur (1) et ladite lentille forme avec la surface de réflexion (13a, 3a) du miroir recouverte d'un film de réflexion de surface, est un angle aigu.

2. Source de lumière de laser accordable semiconducteur à cavité externe selon la revendication 1,
dans laquelle ledit miroir (13, 3) est tournant.

3. Source de lumière de laser accordable semiconducteur à cavité externe selon la revendication 1,
dans laquelle un point d'intersection C de la ligne L1 s'étendant verticalement de l'axe optique du laser semiconducteur dans une position optique C1 d'une face terminale (1b) du laser semiconducteur (1) à partir dudit réseau de diffraction (2) par rapport audit réseau de diffraction pris comme point de départ et d'un prolongement L2 d'une surface de diffraction dudit réseau de diffraction (2) correspond au centre tournant dudit miroir (13, 3) ; et
dans laquelle ledit miroir (13, 3) est placé de sorte que le prolongement L3 de la surface de réflexion (13a, 3a) dudit miroir passe par le point d'intersection C.

4. Source de lumière de laser accordable semiconducteur à cavité externe selon la revendication 1,
dans laquelle ledit miroir (13, 3) comprend un prisme triangulaire (3).

5. Source de lumière de laser accordable semiconducteur à cavité externe selon la revendication 1,
dans laquelle ledit miroir (13, 3) comprend un prisme en forme de parallélogramme (13).
